# EUROPÄISCHE PATENTSCHRIFT

(11) **EP 0 762 650 B1**
(45) Veröffentlichungstag und Bekanntmachung des Hinweises auf die Patenterteilung: **25.08.1999**
(21) Anmeldenummer: 96202425.3
(22) Anmeldetag: 02.09.1996
(51) Int. Cl.: H03K 5/1252

(54) **Schaltungsanordnung zum Erzeugen eines binären Ausgangssignals**
Circuit arrangement for generating a binary output signal
Circuit pour la génération d'un signal de sortie binaire

(30) Priorität: 06.09.1995 DE 19532881; 21.09.1995 DE 19535018
(43) Veröffentlichungstag der Anmeldung: 12.03.1997
(73) Patentinhaber: Philips Patentverwaltung GmbH, 22335 Hamburg (DE); Koninklijke Philips Electronics N.V., 5621 BA Eindhoven (NL)
(72) Erfinder: Wille, Thomas, Dr., c/o Philips, 22335 Hamburg (DE); Ritter, Siegfried, Dr., c/o Philips, 22335 Hamburg (DE); Tammer, Rolf, Dr., c/o Philips, 22335 Hamburg (DE)
(74) Vertreter: Peters, Carl Heinrich, Dipl.-Ing.

(56) Entgegenhaltungen:
- EP-A- 0 137 660
- EP-A- 0 309 849
- EP-A- 0 604 126
- EP-A- 0 639 001
- DE-A- 3 239 936
- US-A- 5 059 834

## Beschreibung

Die Erfindung betrifft eine Schaltungsanordnung zum Erzeugen eines binären Ausgangssignals, mit einem minimalen zeitlichen Abstand zwischen aufeinanderfolgenden Flanken aus einem binären Eingangssignal mit variierendem Flankenabstand,
mit einem Eingangsanschluß für das Eingangssignal,
mit einem ersten und einem zweiten Schaltungszweig, die untereinander gleich aufgebaut sind und von denen jeder eine erste Speicherstufe mit einem Takteingang,
der in dem einen Schaltungszweig direkt und in dem anderen Schaltungszweig über einen Inverter mit dem Eingangsanschluß gekoppelt ist, enthält, und mit einem Zeitglied,
wobei das Ausgangssignal von dem Ausgang der ersten Speicherstufe wenigstens eines Schaltungszweiges abgeleitet ist.

Eine solche Schaltungsanordnung ist unter anderem zweckmäßig zum Rückgewinnen eines störungsfreien Taktsignals aus einem gestörten Eingangstakt. Dieser Fall tritt beispielsweise auf bei integrierten Schaltungen, die kontaktlos oder kontaktbehaftet mit einer Basisstation gekoppelt werden, insbesondere bei Chipkarten. Kontaktlose Chipkarten sind mit einer Basisstation über ein elektromagnetisches Feld gekoppelt, das von der Basisstation ausgesandt wird. Dieses Wechselfeld dient neben der Übertragung von Energie zum Betrieb der integrierten Schaltung in der Chipkarte auch zur Übertragung von Informationen, wobei die Frequenz des Wechselfeldes ein Taktsignal zur Steuerung der Verarbeitung in der Chipkarte darstellen kann. Wenn Chipkarte und Basisstation lose gekoppelt sind, beispielsweise durch einen größeren Abstand zwischen beiden, können eingestreute Störungen zusätzliche Flanken in dem von der Chipkarte aufgenommenen Signal erzeugen, so daß ein daraus rückgewonnenes Taktsignal ebenfalls zusätzliche Flanken enthält und nicht dem von der Basisstation ausgesandten Wechselfeld entspricht. Störungen des Taktsgnals treten auch bei kontaktbehafteten Chipkarten auf, beispielsweise durch Prellen mechanischer Kontakte oder durch in dem Übertragungsweg eingekoppelte Störungen von in der Umgebung betriebenen Schaltelementen.

Eine Schaltungsanordnung der eingangs genannten Art ist bekannt aus der DE 32 39 936 A1. Darin ist in jedem Schaltungszweig der Speicherstufe eine monostabile Kippstufe als Zeitglied nachgeschaltet, deren Ausgangssignal die Speicherstufe im jeweils anderen Zweig rückgesetzt hält. Dies hat jedoch den Nachteil, daß bei einer Impulsdauer des Eingangssignals, der durch Störungen auf eine Impulszeit kürzer als die Monoflopzeit verkürzt ist, die Rückflanke nicht erkannt wird und somit ein ganzer Impuls ausgelassen wird.

Aus der EP 604 126 A2 ist eine Taktsignalschaltung bekannt, die ebenfalls Störungen aus einem empfangenen Taktsignal entfernen soll und insbesondere für die Anwendung bei kontaktlosen Chipkarten vorgesehen ist. Einige darin angegebene Ausführungsbeispiele enthalten zwei Schaltungszweig, die untereinander gleich aufgebaut sind und wenigstens eine Kreuzkopplung aufweisen und bei denen ein Schaltungszweig auf positive Flanken und der andere Schaltungszweig auf negative Flanken reagiert. Das einzige, in Fig. 3 dargestellte Ausführungsbeispiel, mit dem es möglich ist, auch verkürzte Eingangsimpulse zu erfassen, ist jedoch relativ aufwendig aufgebaut. Außerdem werden auch dabei in beiden Schaltungszweigen getrennte Zeitglieder verwendet.

Aufgabe der Erfindung ist es, aus einem beliebig gestörten Eingangssignal ein im wesentlichen periodisches Ausgangssignal mit einer zuverlässig eingehaltenen oberen Taktfrequenz zu erzeugen, wobei der Verlauf eines gestörten periodischen Eingangssignals weitgehend erhalten bleibt und praktisch keine Phasenverschiebung zwischen gestörtem Eingangssignal und aufbereitetem Ausgangssignal hervorgerufen wird, wobei nur ein die maximale Frequenz des Ausgangssignals bestimmendes Zeitglied benötigt wird.

Diese Aufgabe wird gemäß der Erfindung durch eine Schaltungsanordnung gemäß Anspruch 1 gelöst, die in beiden Schaltungszweigen je eine weitere Speicherstufe enthält, wobei jeder Schaltungszweig auf eine andere Richtung der Eingangsflanken anspricht und die beiden Schaltungszweige derart miteinander gekoppelt sind, daß sie nur abwechselnd aktiv sind, wobei der Übergang von einem Schaltungszweig auf den anderen durch den Wechsel des Eingangssignals und durch ein Zeitglied gesteuert wird. Dadurch wird beispielsweise nach einer positiven Flanke eine negative Flanke des Eingangssignals auch dann ausgewertet, wenn diese vor Ablauf der Verzögerungszeit des Zeitglieds auftritt und das Eingangssignal auf negativem Pegel verbleibt.

Das störsignalbefreite Ausgangssignal kann von der ersten Speicherstufe eines Schaltungszweigs abgenommen werden. Durch getrennte Verknüpfung der Ausgangssignale der ersten Speicherstufen beider Schaltungszweige können darüber hinaus zwei sich zuverlässig nicht überlappende Ausgangssignale gewonnen werden.

Ausführungsbeispiele der Erfindung werden nachfolgend anhand der Zeichnung näher erläuert. Es zeigen
Fig. 1 ein Schaltbild einer erfindungsgemäßen Schaltungsanordnung,
Fig. 2 ein Diagramm mit Signalverläufen an verschiedenen Punkten dieser Schaltungsanordnung,
Fig. 3 einen Ausschnitt aus der Fig. 1 mit einer Erweiterung zum Rücksetzen.

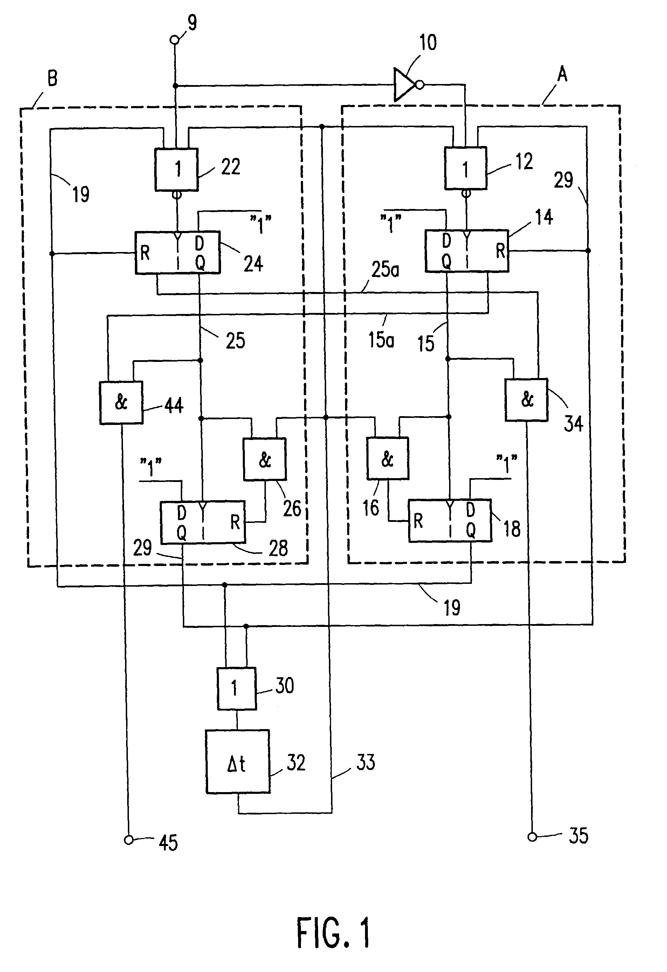

Die in Fig. 1 dargestellte Schaltungsanordnung enthält zwei Schaltungszweige A und B sowie einige beiden Schaltungszweigen gemeinsame Elemente. Beide Schaltungszweige sind untereinander gleichartig aufgebaut.

Der Schaltungszweig A enthält ein NOR-Gatter 12 mit drei Eingängen, von denen ein Eingang über einen Inverter 10 mit einem Anschluß 9 für das Eingangssignal verbunden ist. Der Ausgang des NOR-Gatters 12 führt auf den Takteingang eines flankengesteuerten D-Flipflops 14, dessen D-Eingang an ein Potential entsprechend der logischen "1" angeschlossen ist. Der Ausgang Q des Flipflops 14 führt über die Leitung 15 auf den Takteingang eines weiteren D-Flipflops 18, dessen D-Eingang ebenfalls konstant ein Potential entsprechend der logischen "1" erhält. Die Leitung 15 führt ferner auf einen Eingang eines UND-Gatters 16, dessen Ausgang mit einem Rücksetzeingang R des Flipflops 18 verbunden ist. Der Ausgang Q des Flipflops 18 führt über die Leitung 19 auf einen Eingang eines beiden Schaltungszweigen gemeinsamen ODER-Gatters 30 und auf den anderen Schaltungszweig B, und zwar auf einen Rücksetzeingang eines flankengesteuerten D-Flipflops 24 und auf einen Eingang eines NOR-Gatters 22, dessen Ausgang auf den Takteingang des Flipflops 24 führt. Ein weiterer Eingang des NOR-Gatters ist direkt mit dem Anschluß 9 verbunden. Der Ausgang Q des Flipflops 24 führt über die Leitung 25 auf den Takteingang eines flankengesteuerten D-Flipflops 28 und auf einen Eingang eines UND-Gatters 26, dessen Ausgang mit einem Rücksetzeingang R des Flipflops 28 verbunden ist. Der Ausgang Q des Flipflops 28 führt über die Leitung 29 auf einen weiteren Eingang des ODER-Gatters 30 und auf den Schaltungszweig A, und zwar auf einen Rücksetzeingang R des Flipflops 14 und auf einen weiteren Eingang des NOR-Gatters 12. Der Ausgang des ODER-Gatters 30 steuert ein Zeitglied 32 an, das auf einer Leitung 33 ein Signal erzeugt, dessen positive Flanke der entsprechenden Ausgangsflanke des ODER-Gatters 30 mit einer fest eingestellten Zeitverzögerung folgt und dessen negative Flanke der entsprechenden Ausgangsflanke des Signals des ODER-Gatters 30 im wesentlichen unverzögert folgt. Die Leitung 33 ist in beiden Schaltungszweigen A und B mit einem zweiten Eingang des UND-Gatters 16 bzw. 26 und einem dritten Eingang des NOR-Gatters 12 bzw. 22 verbunden.

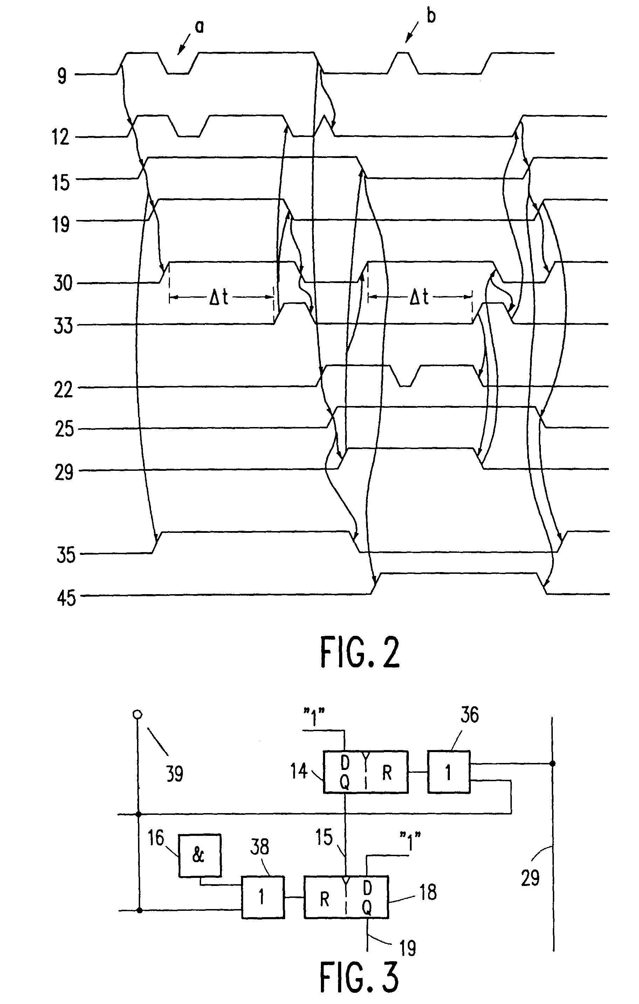

Die Funktion der in Fig. 1 dargestellten Schaltungsanordnung soll nun anhand des Diagramms in Fig. 2 erläutert werden, das den Signalverlauf an verschiedenen Punkten auf verschiedenen Leitungen der Schaltung in Fig. 1 zeigt. Dabei sind die einzelnen Signalverläufe mit den Bezugszeichen gekennzeichnet, die den entsprechenden Elementen bzw. Leitungen mit den gleichen Bezugszeichen entsprechen, an denen diese Signale auftreten. Es wird angenommen, daß die Flipflops 14, 18, 24 und 28 mit einer positiven Flanke eines Signals am Takteingang schalten. Außerdem wird von einer positiven Logik ausgegangen, d.h. ein hohes Potential entspricht der logischen "1". In dem Diagramm in Fig. 1 sind zwischen einzelnen Flanken verschiedener Signale Pfeile angegeben, die deutlich machen sollen, welche Flanke eines Signals durch welche Flanke eines anderen Signals ausgelöst wird.

Zuerst tritt eine positive Flanke im Eingangssignal am Eingang 9 auf, während die Flipflops 14, 18 und 28 zurückgesetzt sind und auf den Leitungen 15, 19 und 29 sowie der Leitung 33 ein niedriges Signal vorhanden ist. Der Zustand des Flipflops 24 und das Signal auf der Leitung 25 sind in diesem Augenblick nicht von Bedeutung. Damit führen zwei der drei Eingänge des NOR-Gatters 12 und im übrigen auch des NOR-Gatters 22 ein niedriges Signal. Durch die positive Flanke des Signals am Eingang 9 wird der Ausgang des Inverters 10 niedrig, und damit wird der Ausgang des NOR-Gatters 12 hoch und triggert das Flipflop 14. Dadurch wird das Signal auf der Leitung 15 hoch und triggert das Flipflop 18, wodurch das Signal auf der Leitung 19 hoch wird und außerdem das UND-Gatter 34 am Ausgang 35 ein hohes Signal abgibt, wenn angenommen wird, daß der andere Eingang dieses UND-Gatters bereits hohes Potential hatte. Das hohe Signal auf der Leitung 19 steuert außerdem über das ODER-Gatter 30 das Zeitglied 32 an, und auf der Leitung 33 erscheint dann nach der Verzögerungszeit Δt eine positive Flanke. Wenn während der Verzögerungszeit Δt eine Störung im Signal am Eingang 9 auftritt, wie der Signaleinbruch an der Stelle a zeigt, wird zwar am Ausgang des NOR-Gatters 12 ein entsprechendes Signal erzeugt, jedoch kann die zweite positive Flanke am Ausgang des NOR-Gatters 12 keine Auswirkung haben, da das Flipflop 14 bereits gesetzt ist und somit seinen Zustand bei weiteren Flanken am Takteingang nicht ändert. Die Änderung des Eingangssignals im Bereich a kann sich ferner bei dem NOR-Glied 22 im Schaltungszweig B nicht auswirken, da die Leitung 19 bereits vorher hohes Potential führte und der Ausgang des NOR-Gatters somit dauernd niedrig ist.

Nach Ablauf der Verzögerungszeit Δt wird angenommen, daß das Signal am Eingang 9 noch hoch ist, und durch die verzögerte ansteigende Flanke auf der Leitung 33 wird über das UND-Gatter 16 das Flipflop 18 zurückgesetzt, so daß das Signal auf der Leitung 19 wieder niedrig wird. Dadurch wird auch das Signal am Ausgang des ODER-Gatters 30 niedrig, wodurch auch das Signal auf der Leitung 33 niedrig wird. Damit ist der Zustand vor der ersten dargestellten Flanke des Signals am Eingang 9 wieder hergestellt, lediglich das Flipflop 14 ist noch gesetzt, so daß das Signal auf der Leitung 15 noch hoch ist, und damit ist auch das Signal am Ausgang 35 noch hoch.

Die Verbindung der Leitung 33 mit einem Eingang des NOR-Gatters 12 bewirkt, daß das Signal am Ausgang des NOR-Gatters 12 mit der Vorderflanke des Signals auf der Leitung 33 niedrig und mit dessen Rückflanke wieder hoch wird. Dieser Signalwechsel hat weiterhin keine Auswirkung auf das Flipflop 14, da dieses immer noch gesetzt ist. Für die grundsätzliche Funktion der Schaltung ist die Verbindung 33 mit einem Eingang des NOR-Gatters 12 ebenso wie mit einem Eingang des NOR-Gatters 22 nicht unbedingt notwendig, es soll dadurch lediglich verhindert werden, daß bei Signalübergängen, die im Eingangssignal zu ganz bestimmten Zeitpunkten nach der positiven Flanke des Signals auf der Leitung 33 auftreten, im Zusammenhang mit ungünstigen Kombinationen von Laufzeiten verschiedener Bauelemente eine Fehlfunktion, nämlich ein Blockierungszustand auftreten kann.

Mit der zweiten negativen Flanke im dargestellten Signal am Eingang 9 wird das Signal am Ausgang des NOR-Gatters 12 endgültig niedrig, und nun wird das Signal am Ausgang des NOR-Gatters 22 im Schaltungszweig B hoch, da die Signale auf den Leitungen 19 und 33 beide niedrig sind. Damit wird das Flipflop 24 umgeschaltet, das Signal 25 wird hoch und das Signal auf der Leitung 25a wird niedrig. Dies bewirkt, daß das Signal am Ausgang 35 niedrig wird, und die positive Flanke des Signals auf der Leitung 25 schaltet das Flipflop 28 um, so daß das Signal auf der Leitung 29 hoch wird und das Flipflop 14 im Schaltungszweig A zurückgesetzt wird und gleichzeitig das NOR-Gatter 12 gesperrt wird. Da diese beiden Vorgänge praktisch gleichzeitig auftreten und außerdem das Flipflop 14 durch das Signal auf der Leitung 29 dauerhaft zurückgesetzt gehalten wird, kann auch unter ungünstigsten Umständen, wenn beispielsweise gerade mit dem Ansteigen des Signals auf der Leitung 29 ein Signalwechsel des Signals am Eingang 9 auftritt, keine Fehlfunktion entstehen.

Die ansteigende Flanke des Signals auf der Leitung 29 steuert über das ODER-Glie d 30 das Zeitglied 32 an, und nach Ablauf der Verzögerungszeit Δt erscheint wieder ein hohes Signal auf der Leitung 33. In der Zwischenzeit können, wie für den Schaltungszweig A beschrieben, Störungen im Signal am Eingang 9, wie beispielsweise im Bereich b, sich nicht auswirken. Die positive Flanke des Signals auf der Leitung 33 blockiert das NOR-Gatter 22, und es setzt über das UND-Glied 26 das Flipflop 28 zurück, so daß das Signal auf der Leitung 29 wieder niedrig wird. Damit wird das NOR-Gatter 12 im Schaltungszweig A aber noch nicht freigegeben, sondern es wird noch über das hohe Signal auf der Leitung 33 blockiert, so daß die positive Flanke im Signal am Eingang 9, die hier beispielsweise infolge einer Störung zu früh praktisch mit Ablauf der Verzögerungszeit des Zeitgliedes auftritt, sich nicht auswirken kann. Durch das niedrige Signal auf der Leitung 29 wird aber über das ODER-Glied 30 das Eingangssignal des Zeitgliedes 32 niedrig, und damit wird das Signal auf der Leitung 33 ebenfalls niedrig und das NOR-Gatter 12 freigegeben. Nun wirkt sich das hohe Signal am Eingang 9 über das NOR-Gatter 12 aus und erzeugt eine ansteigende Flanke, die das Flipflop 14 umschaltet. Auf diese Weise ist die zu frühe Flanke im Signal am Eingang 9 nicht verloren gegangen, sondern wird zu einem Zeitpunkt berücksichtigt, der von der Verzögerungszeit des Zeitglieds abhängt, so daß der minimale Flankenabstand des Ausgangssignals bzw. der Ausgangssignale eingehalten wird. Die nächste Flanke im Signal am Ausgang 35 kann nämlich erst auftreten, wenn durch das Ausgangssignal des Flipflops 14 das Flipflop 18 umgeschaltet und über das dann hohe Signal auf der Leitung 19 das Flipflop 25 zurückgeschaltet ist.

Die positive Flanke im Signal am Ausgang 45 des UND-Gatters 44 konnte erst auftreten, nachdem das Flipflop 14 vorher zurückgesetzt worden war, und liegt somit zwangsläufig nach der negativen Flanke des Signals am Ausgang 35. Entsprechend wird die negative Flanke im Signal am Ausgang 45 erzeugt, wenn das Flipflop 15 gesetzt wird, und dies geschieht zwangsläufig vor dem Rücksetzen des Flipflops 24 und damit vor der positiven Flanke am Ausgang 35. Auf diese Weise stehen an den Ausgängen 35 und 45 zwei sich mit Sicherheit nicht überlappende Signale zur Verfügung.

Bei der Erweiterung der Schaltung in Fig. 1, die in Fig. 3 angedeutet ist, wird durch ein Rücksetzsignal ein definierter Anfangszustand aller Flipflops hergestellt. Die Fig. 3 zeigt der Einfachheit halber nur die beiden Flipflops 14 und 18 im Schaltungszweig A, und es ist klar, daß der Schaltungszweig B in entsprechender Weise erweitert aufgebaut ist. Die Erweiterung besteht darin, daß dem Rücksetzeingang R sowohl des Flipflops 14 als auch des Flipflops 18 ein ODER-Gatter 36 bzw. 38 vorgeschaltet ist. Ein Eingang des ODER-Gatters 36 ist mit der Leitung 29 verbunden, und ein zweiter Eingang ist mit einem Rücksetzanschluß 39 verbunden. Entsprechend ist ein Eingang des ODER-Gatters 38 mit dem Ausgang des UND-Gatters 16 verbunden, und ein zweiter Eingang des ODER-Gatters 38 ist ebenfalls mit der Rücksetzanschluß 39 verbunden. Auf diese Weise wird durch ein hohes Signal am Rücksetzanschluß 39 jedes der Flipflops 14 und 18 sowie 24 und 28 im Schaltungszweig B zurückgesetzt, während die übrige Funktion erhalten bleibt, wie beschrieben wurde, solange das Signal am Rücksetzanschluß 39 niedrig ist.

## Patentansprüche

1. Schaltungsanordnung zum Erzeugen eines binären Ausgangssignals mit einem minimalen zeitlichen Abstand zwischen aufeinanderfolgenden Flanken aus einem binären Eingangssignal mit variierendem Flankenabstand,
mit einem Eingangsanschluß für das Eingangssignal,
mit einem ersten und einem zweiten Schaltungszweig (A, B), die untereinander gleich aufgebaut sind und von denen jeder eine erste Speicherstufe (14, 24) mit einem Takteingang, der in dem einen Schaltungszweig (B) direkt und in dem anderen Schaltungszweig (A) über einen Inverter (10) mit dem Eingangsanschluß (9) gekoppelt ist, enthält, und
mit einem Zeitglied,
wobei das binäre Ausgangssignal von dem Ausgang der ersten Speicherstufe (14, 24) wenigstens eines Schaltungszweiges abgeleitet ist,
dadurch gekennzeichnet, daß in jedem der Schaltungszweige (A, B) dem Takteingang der ersten Speicherstufe (14, 24) ein Sperrglied (12, 22) vorgeschaltet ist und
eine zweite Speicherstufe (18, 28) mit einem Takteingang, der mit einem Ausgang (15, 25) der ersten Speicherstufe (14, 24) gekoppelt ist, und einem Ausgang (19, 29), der mit einem Rücksetzeingang der ersten Speicherstufe (24, 14) und einem Sperreingang des Sperrglieds (22, 12) im jeweils anderen Schaltungszweig und mit dem Eingang des beiden Schaltungszweigen gemeinsamen Zeitgliedes (32) über ein ODER-Glied (30) gekoppelt ist, und
ein erstes Verknüpfungsglied (16, 26) vorgesehen ist, das zwei Eingänge aufweist, von denen der eine Eingang mit dem Ausgang (15, 25) der ersten Speicherstufe (14, 24) desselben Schaltungszweigs und der andere Eingang mit dem Ausgang (33) des Zeitglieds (32) gekoppelt ist, und dessen Ausgang mit einem Rücksetzeingang der zweiten Speicherstufe (18, 28) desselben Schaltungszweigs gekoppelt ist,
wobei das Zeitglied (32) die eine Flanke eines Signals am Eingang um eine vorbestimmte Verzögerungszeit verzögert und die andere Flanke im wesentlichen unverzögert am Ausgang (33) abgibt.

2. Schaltungsanordnung nach Anspruch 1, dadurch gekennzeichnet,
daß das Sperrglied (12, 22) einen weiteren Sperreingang aufweist, der in beiden Schaltungszweigen (A, B) mit dem Ausgang (33) des Zeitglieds (32) gekoppelt ist.

3. Schaltungsanordnung nach Anspruch 1 oder 2, dadurch gekennzeichnet,
daß wenigstens ein Schaltungszweig ein zweites Verknüpfungsglied (34, 44) mit zwei Eingängen und einem Ausgang (35, 45) enthält, von denen der eine Eingang mit dem Ausgang (15, 25) der ersten Speicherstufe (14, 24) desselben Schaltungszweigs und der andere Eingang mit einem invertierten Ausgang der ersten Speicherstufe (24, 14) des anderen Schaltungszweigs verbunden ist und der Ausgang (35, 45) das binäre Ausgangssignal abgibt.

4. Schaltungsanordnung nach Anspruch 3, dadurch gekennzeichnet,
daß das zweite Verknüpfungsglied (34, 44) in beiden Schaltungszweigen (A, B) vorgesehen ist und beide Verknüpfungsglieder abwechselnd nicht überlappende binäre Ausgangssignale an den Ausgängen (35, 45) abgeben.

5. Schaltungsanordnung nach einem der vorhergehenden Ansprüche, dadurch gekennzeichnet,
daß dem Rücksetzeingang jeder Speicherstufe (14, 18, 24, 28) in beiden Schaltungszweigen ein drittes bzw. ein viertes Verknüpfungsglied (36, 38) mit zwei Eingängen vorgeschaltet ist, wobei ein Eingang des dritten Verknüpfungsglieds (36) mit dem Ausgang (29) der betreffenden zweiten Speicherstufe im anderen Schaltungszweig und ein Eingang des vierten Verknüpfungsglieds (38) mit dem Ausgang des ersten Verknüpfungsgliedes (16) und der andere Eingang des dritten und vierten Verknüpfungsglieds (36, 38) mit einem gemeinsamen Rücksetzanschluß (39) verbunden ist.

## Claims

1. A circuit arrangement for generating a binary output signal with a minimum temporal spacing of successive edges from a binary input signal with varying edge spacing, including an input terminal for the input signal,
a first and a second circuit branch (A, B) of identical construction, each of which includes a first storage stage (14, 24) with a clock input which in one circuit branch (B) is coupled directly to the input terminal (9) whereas in the other circuit branch (A) it is coupled thereto via an inverter (10), and
a timing member,
the binary output signal being derived from the output of the first storage stage (14, 24) of at least one circuit branch,
characterized in that in each of the circuit branches (A, B) the clock input of the first storage state (14, 24) is preceded by a blocking member (12, 22), and that there is provided a second storage stage (18, 28) with a clock input which is coupled to an output (15, 25) of the first storage stage (14, 24) and an output (19, 29) which is coupled to a reset input of the first storage stage (24, 14) and a blocking input of the blocking member (22, 12) in each time the respective other circuit branch, and to the input of the timing member (32) which is common to the two circuit branches, via an OR member (30), and that
there is provided a first logic member (16, 26) having two inputs, one input of which is coupled to the output (15, 25) of the first storage stage (14, 24) of the same circuit branch whereas the other input is coupled to the output (33) of the timing member (32), its output being coupled to a reset input of the second storage stage (18, 28) of the same circuit branch, wherein
the timing member (32) delays one edge of a signal at the input by a predetermined delay time and outputs the other edge on the output (33) substantially without delay.

2. A circuit arrangement as claimed in claim 1, characterized in that the blocking member (12, 22) includes a further blocking input which is coupled to the output (33) of the timing member (32) in both circuit branches (A, B).

3. A circuit arrangement as claimed in Claim 1 or 2, characterized in that at least one circuit branch includes a second logic member (34, 44) with two inputs and one output (35, 45), one input of which is coupled to the output (15, 25) of the first storage stage (14, 24) of the same circuit branch, the other input being coupled to an inverting output of the first storage stage (24, 14) of the other circuit branch and the output (35, 45) outputs the binary output signal.

4. A circuit arrangement as claimed in Claim 3, characterized in that the second logic member (34, 44) is provided in both circuit branches (A, B) and the two logic members alternately output non-overlapping binary output signals via the outputs (35, 45).

5. A circuit arrangement as claimed in one of the preceding Claims, characterized in that
the reset input of each storage stage (14, 18, 24, 28) in the two circuit branches is preceded by a third and a fourth logic member (36, 38) having two inputs, an input of the third logic member (36) being coupled to the output (29) of the relevant second storage stage in the other circuit branch and an input of the fourth logic member (38) being coupled to the output of the first logic member (16), the other input of the third and the fourth logic member (36, 38) being connected to a common reset terminal (39).

## Revendications

1. Circuit de production d'un signal de sortie binaire avec un intervalle temporel minimum entre les flancs successifs d'un signal d'entrée binaire avec un intervalle variable entre les flancs,
avec une borne d'entrée pour le signal d'entrée,
avec des première et deuxième branches de circuit (A, B) qui sont de conception similaire et dont chacune contient un premier étage de mémoire (14, 24) avec une entrée de rythme qui est couplée dans l'une des branches de circuit (B) directement et dans l'autre branche de circuit (A) par l'intermédiaire d'un inverseur (10) avec la borne d'entrée (9) et
avec un organe temporisateur,
le signal de sortie binaire étant dérivé de la sortie du premier étage de mémoire (14, 24) d'au moins une branche de circuit,
caractérisé en ce que, dans chacune des branches de circuit (A, B) un organe de blocage (12, 22) est monté en amont de l'entrée de rythme du premier étage de mémoire (14, 24) et
un deuxième étage de mémoire (18, 28) est couplé à une entrée de rythme qui est elle-même couplée à une première sortie (15, 25) du premier étage de mémoire (14, 24) et à une sortie (19, 29) qui est couplée à une entrée de réinitialisation du premier étage de mémoire (24, 14) et à une entrée de blocage de l'organe de blocage (22, 12) dans l'autre branche de circuit respective et avec l'entrée de l'organe temporisateur (32) commun aux deux branches de circuit par l'intermédiaire d'un organe OU (30) et
un premier organe de liaison (16, 26) est prévu et présente deux entrées dont l'une est reliée à la sortie (15, 25) du premier étage de mémoire (14, 24) de la même branche de circuit et l'autre entrée à la sortie (33) de l'organe temporisateur (32) et dont la sortie est couplée à une entrée de réinitialisation du deuxième étage de mémoire (18, 28) de la même branche de circuit, l'organe temporisateur (32) retardant l'un des flancs d'un signal à l'entrée d'un temps de retard préalablement déterminé et délivrant l'autre flanc à la sortie (33) essentiellement sans retard.

2. Circuit selon la revendication 1, caractérisé en ce
que l'organe de blocage (12, 22) présente une autre entrée de blocage qui est couplée dans les deux branches de circuit (A, B) à la sortie (33) de l'organe temporisateur (32).

3. Circuit selon l'une des revendications 1 ou 2, caractérisé en ce
qu'au moins une branche de circuit contient un deuxième organe de liaison (34, 44) avec deux entrées et une sortie (35, 45) dont l'une des entrées est reliée à la sortie (15, 25) du premier étage de mémoire (14, 24) de la même branche de circuit et l'autre entrée à une sortie inversée du premier étage de mémoire (24, 14) de l'autre branche de circuit et la sortie (35, 45) délivre le signal de sortie binaire.

4. Circuit selon la revendication 3, caractérisé en ce
que le deuxième organe de liaison (34, 44) est prévu dans les deux branches de circuit (A, B) et les deux organes de liaison délivrent en alternance des signaux de sortie binaires qui ne se chevauchent pas aux sorties (35, 45).

5. Circuit selon l'une des revendications précédentes, caractérisé en ce
que des troisième et quatrièm organes de liaison (36, 38) avec deux entrées sont montés en amont de l'entrée de réinitialisation de chaque étage de mémoire (14, 18, 24, 28) dans les deux branches de circuit, une entrée du troisième organe de liaison (36) étant reliée à la sortie (29) du deuxième étage de mémoire correspondant dans l'autre branche de circuit et une entrée du quatrième organe de liaison (38) étant reliée à la sortie du premier organe de liaison (16) et l'autre entrée des troisième et quatrième organes de liaison (36, 38) avec une borne de réinitialisation (39) commune.
